# EUROPEAN PATENT APPLICATION

(11) **EP 4 620 578 A1**
(43) Date of publication of application: **24.09.2025**
(21) Application number: 22965695.4
(22) Date of filing: 14.11.2022
(51) Int. Cl.: B05C 1/12, B05D 1/28

(54) **COATING DEVICE, MENISCUS HEAD, AND COATING METHOD**

(71) Applicant: Kabushiki Kaisha Toshiba, Tokyo 105-0023 (JP); Toshiba Energy Systems & Solutions Corporation, Saiwai-ku Kawasaki-shi Kanagawa 2120013 (JP)
(72) Inventor: SHIDA, Naomi, Tokyo 105-0023 (JP); NAITO, Katsuyuki, Kawasaki-shi, Kanagawa 210-0024 (JP); SAITA, Yutaka, Kawasaki-shi, Kanagawa 212-0013 (JP)
(74) Representative: Marks & Clerk LLP
(86) International application number: PCT/JP2022/042173
(87) International publication number: WO 2024/105718

(57) **Abstract**

According to an embodiment, provided are a coating device, a meniscus head, and a coating method capable of obtaining a uniform coating film with a large area. A coating device according to an embodiment forms a coating film by a meniscus method, the coating device comprising: a member that conveys a base material; a coating bar; a slot die that supplies a coating liquid to a surface of the coating bar; and a member that supplies the coating liquid to the slot die, in which each of the members is disposed such that the coating liquid supplied from the slot die is supplied to a space between the coating bar and the base material via the surface of the coating bar to form a meniscus.

## Description

### TECHNICAL FIELD

Embodiments of the present invention relate to a coating device, a meniscus head, and a coating method.

### BACKGROUND ART

An organic thin-film solar cell and an organic/inorganic hybrid solar cell using an organic semiconductor are expected as low-cost solar cells because an inexpensive coating method can be applied when forming an active layer. To realize the organic thin-film solar cell and the organic/inorganic hybrid solar cell at low cost, it is required to uniformly coat a coating material for forming an organic active layer and other layers. The thickness of each layer is about several nm to several 100 nm, and it is required to form such an extremely thin layer to a large area with good uniformity. For example, a meniscus coating method is known as one of roll-to-roll (R2R) coating methods capable of coating an extremely thin layer to a large area at low cost. As the meniscus coating method, a method of supplying a liquid to a coating bar from a plurality of nozzles to obtain a coating film with a large area is simple, and a structure of an instrument is also simple. However, it may be difficult to obtain a uniform film thickness by controlling a film thickness of an intermediate portion of the adjacent nozzle to be the same as a film thickness of other portions.

### CITATION LIST

### PATENT LITERATURE

Patent Literature 1: JP 2016-155113 A

### SUMMARY OF THE INVENTION

### OBJECT OF THE INVENTION

An object of the present invention is to provide a coating device, a meniscus head, and a coating method capable of obtaining a uniform coating film with a large area.

### SOLUTION TO PROBLEM

The provided embodiments are described as follows.
[1] A coating device configured to supply a coating liquid to a surface of a base material and to form a coating film by a meniscus method, the coating device comprising:
   a member that conveys the base material;
   a coating bar;
   a slot die that supplies the coating liquid to a surface of the coating bar; and
   a coating liquid supply member that supplies the coating liquid to the slot die,
   in which each of the members is disposed such that the coating liquid supplied from the slot die is supplied to a space between the coating bar and the base material via the surface of the coating bar to form a meniscus.
[2] The coating device according to [1], in which a cross-sectional shape of the coating bar in a plane perpendicular to a longitudinal direction is constant.
[3] The coating device according to [1] or [2], further comprising a position detection member that detects that a longitudinal direction of the coating bar and a coating liquid discharge port of the slot die are parallel to each other.
[4] The coating device according to any one of [1] to [3], further comprising an interval measuring member that measures an interval between the coating bar and the slot die.
[5] The coating device according to [4], in which the interval measuring member measures the interval by measuring electric resistance between the coating bar and the slot die.
[6] The coating device according to any one of [1] to [5], further comprising an interval control member that controls a distance between the coating bar and the slot die.
[7] The coating device according to any one of [1] to [6], in which the number of the coating liquid supply members is equal to or smaller than the number of the slot dies.
[8] The coating device according to any one of [1] to [7], in which there are a plurality of the slot dies.
[9] The coating device according to [8], further comprising a slot die interval adjustment member that adjusts an interval between slot dies adjacent to each other.
[10] A meniscus head disposed apart from a base material and supplying a coating liquid to a surface of the base material to form a coating film, the meniscus head comprising:
   a coating bar;
   a slot die that supplies the coating liquid to a surface of the coating bar; and
   a fixing member that connects and fixes the coating bar to the slot die,
   in which the coating liquid discharged from the slot die is supplied to a gap between the coating bar and the base material via the surface of the coating bar to form a meniscus and to form the coating film.
[11] The meniscus head according to [10], in which a length of the coating bar in a longitudinal direction is equal to or greater than 30 cm, and a length of a coating liquid discharge port of the slot die is equal to or less than 10 cm.
[12] A coating method of forming a coating film on a surface of a base material by supplying a coating liquid to a space between a coating bar and the base material and forming a meniscus, the coating method comprising:
   (S31) a step of supplying the coating liquid to a slot die and removing air;
   (S32) a step of controlling an interval between the coating bar and the slot die;
   (S33) a step of controlling an interval between the coating bar and the base material;
   (S34) a step of supplying the coating liquid from the slot die to a space between the coating bar and the base material via a surface of the coating bar to form the meniscus; and
   (S35) a step of conveying the base material to form the coating film.
[13] The coating method according to [12], in which a length of the coating bar in a longitudinal direction is equal to or greater than 30 cm, and a length of a coating liquid discharge port of the slot die is equal to or less than 10 cm.
[14] The coating method according to [12] or [13], in which a viscosity of the coating liquid at a temperature during coating is equal to or less than 2 × 10⁻³ kg·m/s.
[15] The coating method according to any one of [12] to [14], in which, in the step (S32), a method of measuring the interval between the coating bar and the slot die is to measure electric resistance between the coating bar and the slot die.
[16] The coating method according to any one of [12] to [15], further comprising a step of confirming that a coating liquid discharge port of the slot die is disposed parallel to the coating bar.
[17] The coating method according to any one of [12] to [16], in which supply of the coating liquid is started before the base material is conveyed to form the meniscus between the coating bar and the base material.

### BRIEF DESCRIPTION OF DRAWINGS

[Fig. 1A] Fig. 1A is a conceptual side view illustrating a coating device according to an embodiment.
[Fig. 1B] Fig. 1B is a conceptual top view illustrating the coating device according to the embodiment.
[Fig. 2] Fig. 2 is a conceptual view of a meniscus head according to an embodiment.
[Fig. 3] Fig. 3 is a flowchart of a coating method according to an embodiment.

### BEST MODE FOR CARRYING OUT THE INVENTION

Hereinafter, embodiments will be described with reference to the drawings.

Note that the same reference numerals are assigned to the same configurations throughout the embodiments, and a redundant description thereof will be omitted. In addition, each drawing is a schematic view for promoting the embodiments and the understanding thereof, the shape, size, ratio, and the like are different from those of the actual device, and the shape, size, ratio, and the like can be appropriately changed in design considering the following description and known techniques.

### (First Embodiment)

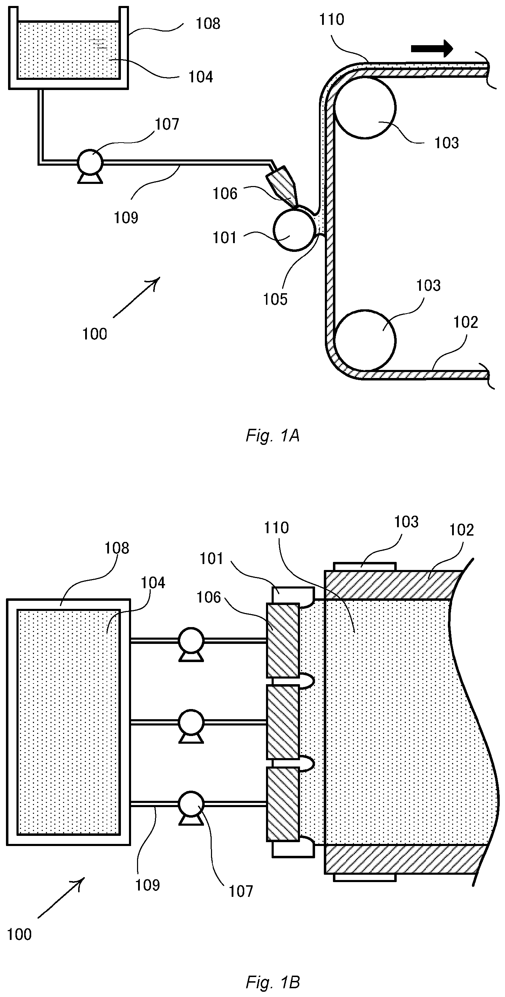

Figs. 1A and 1B are a conceptual side view and a conceptual top view each illustrating a coating device according to an embodiment. A coating device 100 comprises:
a member 103 that conveys a base material 102;
a coating bar 101;
a slot die 106 that supplies a coating liquid 104 to a space between the coating bar 101 and the base material 102 to form a meniscus 105; and
a coating liquid supply member 107 (a liquid feed pump or the like, illustrated as one in the drawing) that supplies the coating liquid to the slot die.

The coating device can further comprise a coating liquid tank 108 and a pipe 109. Such members feed the coating liquid 104 stored in the coating liquid tank 108 to the slot die 106.

The base material conveyed from the coating device is usually conveyed to a drying device (not illustrated) and is dried.

In the coating device according to the embodiment, each of the members is disposed such that the coating liquid discharged from the slot die is not directly applied to the surface of the base material, but the coating liquid supplied from the slot die is supplied to a space between the coating bar and the base material via the surface of the coating bar to form the meniscus.

The number of slot dies may be one, or a plurality of slot dies may be arranged as illustrated in Fig. 1B. By arranging the slot dies in parallel to each other, flows of the coating liquids discharged from the respective slot dies are combined with each other at the coating bar surface to form a wide flow of the coating liquid, that forms the meniscus, thereby making it possible to form a uniform and wide coating film.

As one of coating methods of forming a coating film on a base material, meniscus coating is known. The "meniscus" is a phenomenon in which a surface of a liquid forms a concave or convex curved surface. When a coating liquid containing various materials is injected into a space between a coating bar and the base material, the meniscus is formed on the liquid surface. When the base material is moved while the meniscus is formed, the coating film can be formed on the base material.

In meniscus coating using a coating bar, a liquid is generally supplied to the coating bar by a syringe needle. In addition, when continuous coating is required as in a roll-to-roll method (sometimes referred to as R2R), a coating liquid is often supplied from a plurality of needles to a single coating bar. Here, an interval between the adjacent needles varies depending on physical properties of a coating liquid to be used, a coating liquid film, a specific speed, and the like. Since the number of needles that can be arranged for a single coating bar is limited as a supply structure of the coating liquid becomes complicated, it is difficult to use a long coating bar. In addition, it is difficult to stably supply the coating liquid to an intermediate portion of the adjacent needles, and streaks may occur in the coating liquid.

In coating by a slot die (slot coating), a liquid is generally supplied to one slot die. When a wide coating width is required, a discharge port of the slot die also becomes long. A coating liquid is usually injected into the slot die from a central injection port, and the coating liquid is distributed to the entire discharge port. When a viscosity of the coating liquid is small, pressure is less likely to be transmitted to both end sides of the discharge port of the long slot die, and it is difficult to uniformly discharge the liquid from the slot die discharge port.

In the coating device according to the present embodiment, a coating liquid discharged from a slot die is supplied to a surface of a base material via a coating bar, thereby performing meniscus coating. According to such method, a coating film with improved uniformity can be formed even when the coating liquid is unevenly discharged from the slot die. Furthermore, by using a plurality of slot dies, even in meniscus coating using a long coating bar, it is possible to perform uniform coating liquid supply from a plurality of short slot dies to the coating bar, thereby making it possible to perform uniform coating in a large area as well. In a method in which a plurality of short slot dies are arranged without using the coating bar and discharge liquids from the slot dies are directly coated on the base material, the coating film between the slot dies tends to be non-uniform. On the other hand, in the present embodiment in which the coating liquid is supplied to the surface of the base material via the coating bar, the coating liquid is easily distributed uniformly on the coating bar.

In the coating device according to the present embodiment, the cross-sectional shape of the coating bar in a plane perpendicular to the longitudinal direction can be constant. The cross-sectional shape of the coating bar 101 is arbitrary. The cross-sectional shape of the coating bar 101 is, for example, a circular shape, a flat circular shape, or a polygonal shape. A portion of the cross-sectional shape may be a curved shape, and other portions may be a linear shape. For example, the cross-sectional shape of the surface of the coating bar 101 facing the base material 102 may be a curved shape.

The coating bar 101 preferably comprises, for example, at least one selected from a group consisting of stainless steel, aluminum, titanium, and glass. Accordingly, processing of the coating bar 101 is facilitated. In one example, the surface of the coating bar 101 is a mirror surface. In another example, the surface of the coating bar 101 may have an uneven portion.

In the embodiment, the longitudinal direction of the coating bar and the coating liquid discharge port of the slot die are preferably parallel to each other. Therefore, it is possible to have a position detection member that detects that the longitudinal direction of the coating bar and the coating liquid discharge port of the slot die are parallel to each other before start of coating or during coating. As a detection method, an optical method is preferable, and an image camera is preferable.

In the coating device according to the present embodiment, it is preferable to control a distance between the coating bar and the slot die during coating. Therefore, it is possible to further comprise an interval measuring member that measures an interval between the coating bar and the slot die before start of coating or during coating. Here, in the coating device according to the embodiment, the coating bar and the slot die may be in contact with each other. When the coating bar and the slot die are in contact with each other, the coating liquid can be directly coated on the coating bar, and repelling of the coating liquid tends to hardly occur. Therefore, the interval measuring member can be used as a device that detects contact between the coating bar and the slot die. The contact between the coating bar and the slot die is easily detected, and uniformity of the coating film can be improved by maintaining a contact state therebetween.

In addition, in the coating device according to the present embodiment, a member that measures electric resistance between the coating bar and each slot die (an electric resistance measuring device) can be used as the interval measuring member. When the slot die and the coating bar are made of stainless steel or the like having conductivity and a plurality of slot dies are provided, if the slot dies are insulated from each other, by measuring electric resistance between the coating bar and the slot die, the contact can be detected as the electric resistance is drastically reduced at the moment of contact. In addition, since the electric resistance also changes depending on a contact state, the contact state can be monitored.

It is desirable to install wiring connected to the electric resistance measuring device in advance to the slot die and the coating bar. The wiring can be provided with an opening/closing part, and the slot die can be moved to confirm the contact state with the coating bar before coating. In addition, if the electric resistance is continuously measured during coating as well, it is possible to detect a case in which there is an abnormality in contact between the slot die and the coating bar. The electric resistance measuring device can also be an external device separated from the coating device.

The coating device according to the present embodiment can comprise coating liquid supply members, for example, pumps, the number of which is smaller than the number of slot dies. For example, as illustrated in Fig. 1B, one coating liquid supply member can be disposed in each of the plurality of slot dies, and for example, the coating liquid can be supplied from one coating liquid supply member to three slot dies. In the present embodiment, even if the coating liquid is non-uniformly supplied to the plurality of slot dies, the coating liquid discharged from the slot die is uniformly supplied on the coating bar, and thus, for example, uniformity of a coating film is higher than that of a case in which the coating liquid is directly supplied from the slot die onto the base material, in general slot coating.

When the coating device according to the present embodiment comprises a plurality of slot dies, a member that controls an interval between the slot dies can be provided. An example of the member that controls the interval between the slot dies comprises a spacer provided between the slot dies.

In the coating device according to the embodiment, the slot die can be individually attached and detached.

In the coating device according to the embodiment, a pipe for supplying the coating liquid to the slot die may comprise a joint that can be attached to and detached from the slot die. With such a structure, the individual slot die can be easily attached and detached.

The coating device according to the embodiment can comprise each pipe connected from one coating liquid tank to each slot die. As a result, the arrangement of the pipes can be simplified, and it is easy to uniformly control the supply amount of the coating liquid to each pipe by uniformly applying pressure from the tank.

In the coating device according to the embodiment, the moving direction of the base material is not particularly limited, but it is preferable to coat the base material while conveying the base material from the bottom to the top in the vertical direction. By moving the base material from the bottom to the top in the vertical direction, gravity is applied to a meniscus portion, such that a uniform film can be easily formed, and coating can be performed at a higher speed. However, the moving direction can be adjusted depending on the configuration of the device, the physical properties of the coating liquid, and the like, and is generally in the range of ±30° from the vertical direction.

A base material conveyance member preferably conveys the base material from the bottom to the top, and here, the slot die is preferably disposed to supply the coating liquid from an upper portion of the coating bar. Liquid dripping can be suppressed by supplying the coating liquid from the upper portion of the coating bar.

The coating device according to the embodiment may further comprise a member that measures and controls a distance between the coating bar and the base material. Since the meniscus is formed between the coating bar and the base material, the uniformity of the thickness of the coating film can be further increased by controlling the distance between the coating bar and the base material.

The coating device according to the embodiment may further comprise a member that cleans the coating bar. As a result, the coating bar can be periodically washed to remove impurities mixed from the atmosphere and solid matters precipitated from the coating liquid. Specific examples thereof comprise a member that sprays or emits a solvent such as water, a member that applies ultrasonic waves, and the like.

The coating device according to the embodiment can further comprise a member that collects an excessive coating liquid. By providing such a member, it is easy not only to prevent a reverse flow of the coating liquid and loss of the expensive coating liquid after completion of coating, but also to prevent release of the solvent or the like to the environment.

### (Second Embodiment)

A second embodiment relates to a meniscus head. The meniscus head according to the embodiment is used, for example, as a part of the coating device 10 (and a modification thereof) described in relation to the first embodiment.

In the meniscus head according to the embodiment,
the meniscus head comprises:
a coating bar;
a slot die that supplies the coating liquid to a surface of the coating bar; and
a fixing member that connects and fixes the coating bar to the slot die.

The coating liquid discharged from the slot die is supplied to a gap between the coating bar and the base material disposed apart from the coating bar via the surface of the coating bar to form a meniscus, and the base material is conveyed to form a coating film.

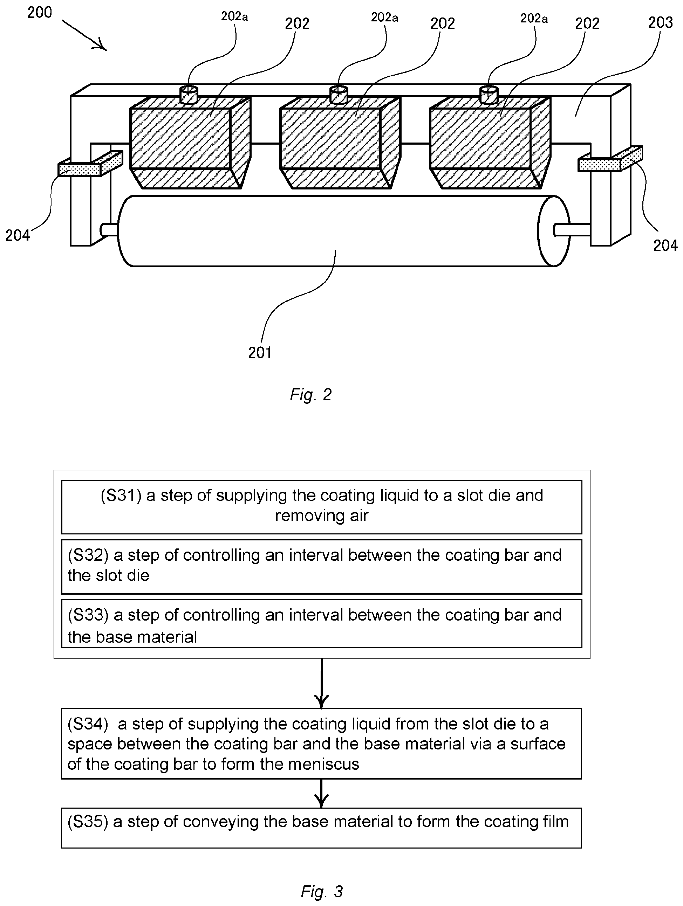

Fig. 2 is a conceptual view of a meniscus head 200 of the present embodiment. The meniscus head 200 comprises a coating bar 201, a plurality of slot dies 202 (three in Fig. 2) for supplying the coating liquid to the coating bar, and a fixing member 203 for the coating bar and the slot die.

The fixing member can adopt various structures, and a structure that is easy to remove and easy to clean is preferable. It is preferable that a shaft of the coating bar and a shaft connecting the respective slot dies to each other are connected and fixed to each other, and an interval between the coating bar and a discharge port of the slot die is adjusted by an adjustment member 204.

Each of the slot dies preferably comprises a member (not illustrated) for removing air mixed into the slot die after the coating liquid is introduced into the slot die from a coating liquid introduction port 202a.

In the meniscus head 200 of the embodiment, a length of the coating bar in the longitudinal direction may be equal to or greater than 30 cm, and a length of a coating liquid discharge port (not illustrated) of the slot die 202 may be equal to or less than 10 cm.

### (Third Embodiment)

The third embodiment relates to a coating method. In the coating method according to the embodiment, for example, coating is performed using the coating device 100 (and a modification thereof) described in relation to the first embodiment.

Fig. 3 is a flowchart illustrating a coating method S30 according to the third embodiment. A coating method of preparing a meniscus between a coating bar and a base material and coating the base material, the coating method comprising:
(S31) a step of supplying the coating liquid to a slot die and removing air;
(S32) a step of controlling an interval between the coating bar and the slot die;
(S33) a step of controlling an interval between the coating bar and the base material;
(S34) a step of supplying the coating liquid from the slot die to a space between the coating bar and the base material via a surface of the coating bar to form the meniscus; and
(S35) a step of conveying the base material to form the coating film.
The order of steps S31 to S33 may be switched.

In the coating method according to the present embodiment, a length of the coating bar in the longitudinal direction can be equal to or greater than 30 cm, and a length of the discharge port of the slot die can be equal to or less than 10 cm.

In the coating method according to the present embodiment, a viscosity of the coating liquid at a temperature during coating can be equal to or less than 2 × 10⁻³ kg·m/s (2 cp).

In the step (S32) of the coating method according to the present embodiment, a method of confirming the interval between the slot die and the coating bar may be to measure electric resistance therebetween.

In the coating method according to the present embodiment, a coating liquid discharge port of the slot die is preferably parallel to the coating bar, and the coating method may further comprise a step of confirming that the coating liquid discharge port and the coating bar are arranged to be parallel to each other.

In the coating method according to the present embodiment, it is preferable that the supply of the coating liquid is started before the base material is conveyed to form the meniscus between the coating bar and the base material. A uniform film can be formed by starting conveyance of the base material after the meniscus is formed.

### (Example 1)

In Example 1, a transparent electrode film is produced as follows using the coating device 100 illustrated in Fig. 1A. A SUS303 coating bar having a cross-sectional shape of a circle having a radius of 10 mm in a plane perpendicular to the longitudinal direction and a length of 300 mm in the coating width direction, and three slot dies having a length of a discharge port of 95 mm are used.

A Teflon tube is connected to each of the slot dies by an attachable and detachable joint, and a coating liquid is supplied to each of the slot dies by three small pumps. As the coating liquid, a silver nanowire aqueous dispersion liquid having a viscosity of 1.7 × 10⁻³ kg·m/s at a temperature during coating is prepared. The coating liquid is supplied to the slot die and air is removed. An interval between the coating bar and each slot die is adjusted, and it is confirmed that an outlet of the slot die is parallel to the coating bar. A PET base material is used as a base material, and the coating bar is disposed using an actuator such that a minimum gap distance between the coating bar and the PET base material is 200 µm. A meniscus column is formed by supplying 0.2 mL of the coating liquid from each of the slot dies before conveying the base material. While controlling the gap distance between the coating bar and the PET base material, the PET base material is conveyed and the coating liquid is continuously supplied to obtain a coating film. The moving speed of the PET base material is constant at 83 mm/s. After coating, the PET base material is continuously dried in a hot air drying furnace corresponding to R2R. The prepared coating film has high uniformity.

### (Comparative Example 1)

Instead of the coating device illustrated in Fig. 1A, coating is performed using a coating device using 16 needle nozzles instead of the slot die. A slight streak is visually observed in the obtained coating film.

### (Comparative Example 2)

Instead of the coating device illustrated in Fig. 1A, coating is performed by a coating device using a single slot die having a length of 30 cm without using a coating bar. A coating film having a thin film thickness at both ends of the coating film is obtained.

### (Comparative Example 3)

Instead of the coating device illustrated in Fig. 1A, coating is performed by a coating device comprising three slot dies and not comprising a coating bar. In the coating film, a streak is seen in the middle of the slot die.

### (Example 2)

An ITO/Ag alloy/iTO transparent electrode having sheet resistance of 10 Ω/□ is prepared on a rolled PET film having a width of 300 mm by an R2R-compatible sputtering device. Next, the transparent electrode is patterned by laser scribing into a strip shape having a separation region with a cell pitch of 12 mm and a width of 50 µm.

Coating is performed on the coating device illustrated in Fig. 1A using a coating device in which the shape of the coating bar is changed. Specifically, a film is formed using a coating device comprising a SUS303 coating bar having a trapezoidal cross section, a wide bottom surface having a curvature radius of 80 mm, and a longitudinal length of 300 mm, and three slot dies each having a discharge port having length of 95 mm.

A PEDOT/PSS aqueous dispersion liquid is prepared as a coating liquid for producing a hole transport layer, and the coating bar is disposed using an actuator such that a minimum gap distance between the coating bar and a PET base material having a transparent electrode formed thereon is 150 µm.

After removing air in the slot die, it is confirmed by measuring electric resistance that the coating bar and the slot die are in contact with each other, and a meniscus column is formed by supplying the coating liquid from the slot die to the coating bar before conveying the base material. The PET base material is conveyed, and the coating liquid is continuously supplied to obtain a coating film. The moving speed of the PET base material is constant at 83 mm/s. The coating film is continuously dried in a hot air drying furnace corresponding to R2R.

Next, 8 mg of PTB7 ([poly{4,8-bis[(2-ethylhexyl) oxy]benzo[1,2-b:4,5-b']dithiophene-2,6-diyl-1t-alt-3-fluoro-2-[(2-ethylhexyl)carbonyl]thieno[3,4-b]thiophene-4,6-diyl}]/p-type semiconductor) and 12 mg of PC70BM ([6,6]phenyl C₇₁ butyric acid methylester/n-type semiconductor) are dispersed in 1 mL of monochlorobenzene, thereby preparing a coating liquid as a material for forming an organic active layer of a solar cell. The coating bar is disposed on the PET base material having a hole transport layer formed thereon using an actuator such that a minimum gap distance between the coating bar and the PET base material is 300 µm. The meniscus column is formed by supplying the coating liquid from each of the slot dies to the coating bar before conveying the base material. While controlling a distance of the PET base material of the slot die, the PET base material is conveyed and the coating liquid is continuously supplied to obtain a coating film. The moving speed of the PET base material is constant at 83 mm/s. The PET base material is continuously dried in a hot air drying furnace corresponding to R2R. Both the prepared coating films are uniform.

Although some embodiments of the present invention have been described, the embodiments have been presented as examples, and are not intended to limit the scope of the invention. The novel embodiments can be implemented in various other forms, and various omissions, substitutions, and changes can be made without departing from the gist of the invention. The embodiments and modifications thereof are included in the scope and gist of the invention, and are included in the invention described in the claims and the scope equivalent thereto.

### REFERENCE SIGNS LIST

- 100: Coating device
- 101: Coating bar
- 102: Base material
- 103: Conveyance member
- 104: Coating liquid
- 105: Meniscus
- 106: Slot die
- 107: Coating liquid supply member
- 108: Coating liquid tank
- 109: Pipe
- 110: Coating film
- 200: Meniscus head
- 201: Coating bar
- 202: Slot die
- 203: Fixing member
- 204: Interval adjustment member

## Claims

1. A coating device configured to supply a coating liquid to a surface of a base material and to form a coating film by a meniscus method, the coating device comprising:
a member that conveys the base material;
a coating bar;
a slot die that supplies the coating liquid to a surface of the coating bar; and
a coating liquid supply member that supplies the coating liquid to the slot die,
wherein each of the members is disposed such that the coating liquid supplied from the slot die is supplied to a space between the coating bar and the base material via the surface of the coating bar to form a meniscus.

2. The coating device according to claim 1, wherein a cross-sectional shape of the coating bar in a plane perpendicular to a longitudinal direction is constant.

3. The coating device according to claim 1 or 2, further comprising a position detection member that detects that a longitudinal direction of the coating bar and a coating liquid discharge port of the slot die are parallel to each other.

4. The coating device according to claim 1 or 2, further comprising an interval measuring member that measures an interval between the coating bar and the slot die.

5. The coating device according to claim 4, wherein the interval measuring member measures the interval by measuring electric resistance between the coating bar and the slot die.

6. The coating device according to claim 1 or 2, further comprising an interval control member that controls a distance between the coating bar and the slot die.

7. The coating device according to claim 1 or 2, wherein the number of the coating liquid supply members is equal to or smaller than the number of the slot dies.

8. The coating device according to claim 1 or 2, wherein there are a plurality of the slot dies.

9. The coating device according to claim 8, further comprising a slot die interval adjustment member that adjusts an interval between the slot dies adjacent to each other.

10. A meniscus head disposed apart from a base material and supplying a coating liquid to a surface of the base material to form a coating film, the meniscus head comprising:
a coating bar;
a slot die that supplies the coating liquid to a surface of the coating bar; and
a fixing member that connects and fixes the coating bar to the slot die,
wherein the coating liquid discharged from the slot die is supplied to a gap between the coating bar and the base material via the surface of the coating bar to form a meniscus and to form the coating film.

11. The meniscus head according to claim 10, wherein a length of the coating bar in a longitudinal direction is equal to or greater than 30 cm, and a length of a coating liquid discharge port of the slot die is equal to or less than 10 cm.

12. A coating method of forming a coating film on a surface of a base material by supplying a coating liquid to a space between a coating bar and the base material and forming a meniscus, the coating method comprising:
(S31) a step of supplying the coating liquid to a slot die and removing air;
(S32) a step of controlling an interval between the coating bar and the slot die;
(S33) a step of controlling an interval between the coating bar and the base material;
(S34) a step of supplying the coating liquid from the slot die to a space between the coating bar and the base material via a surface of the coating bar to form the meniscus; and
(S35) a step of conveying the base material to form the coating film.

13. The coating method according to claim 12, wherein a length of the coating bar in a longitudinal direction is equal to or greater than 30 cm, and a length of a coating liquid discharge port of the slot die is equal to or less than 10 cm.

14. The coating method according to claim 12 or 13, wherein a viscosity of the coating liquid at a temperature during coating is equal to or less than 2 × 10⁻³ kg·m/s.

15. The coating method according to claim 12 or 13, wherein, in the step (S32), a method of measuring the interval between the coating bar and the slot die is to measure electric resistance between the coating bar and the slot die.

16. The coating method according to claim 12 or 13, further comprising a step of confirming that a coating liquid discharge port of the slot die is disposed parallel to the coating bar.

17. The coating method according to claim 12 or 13, wherein supply of the coating liquid is started before the base material is conveyed to form the meniscus between the coating bar and the base material.
